# EUROPEAN PATENT SPECIFICATION

(11) **EP 3 355 363 B1**
(45) Date of publication and mention of the grant of the patent: **28.12.2022**
(21) Application number: 16816964.7
(22) Date of filing: 28.03.2016
(51) Int. Cl.: H01L 31/05, H01L 31/042, H01L 31/0224

(54) **SOLAR CELL MODULE**
SOLARZELLENMODUL
MODULE DE CELLULES SOLAIRES

(30) Priority: 02.07.2015 CN 201510381209; 17.02.2016 CN 201610089428
(43) Date of publication of application: 01.08.2018
(73) Proprietor: CSI Cells Co. Ltd., Suzhou, Jiangsu 215129 (CN)
(72) Inventor: WAN, Songbo, Suzhou Jiangsu 215129 (CN); WANG, Xusheng, Suzhou Jiangsu 215129 (CN); XING, Guoqiang, Suzhou Jiangsu 215129 (CN)
(74) Representative: DREISS Patentanwälte PartG mbB
(86) International application number: PCT/CN2016/077563
(87) International publication number: WO 2017/000599

(56) References cited:
- EP-A1- 2 249 398
- EP-A2- 2 020 688
- WO-A2-2012/037191
- CN-A- 102 569 438
- CN-A- 103 943 698
- CN-A- 104 966 746

## Description

### TECHNICAL FIELD

The present invention relates to the field of solar cells, and particularly relates to a solar cell module.

### BACKGROUND

Conventional fossil fuel runs out day by day. Among various sustainable energy sources, solar energy is undoubtedly the cleanest, the most common and the most promising alternative energy source. Photovoltaic power generation is one of power generation technologies with the most sustainable development ideal features. Currently, in various solar cells, the silicon solar cell is one of the solar cells which is commercially promoted widely because silicon is abundant in earth crust and the silicon solar cell has excellent electrical performance and mechanical performance compared with other types of solar cells. In future development of photovoltaic technologies, as the photoelectric performance of the silicon solar cells is further enhanced and the price of the silicon is further reduced, the silicon solar cells will hold a significant position in photovoltaic field.

In an existing art, a solar cell module formed by cells generally includes a plurality of solar cell strings packaged by a packaging structure. The solar cell string includes a plurality of solar cell sheets connected in series. The solar cell is provided with at least two busbars. When connected in series, two adjacent cells are electrically connected through a ribbon. The quantity of the ribbons is equal to the quantity of the busbars. Currently, the ribbons commonly used in the industry are flat bar-type ribbons. A ratio of a total width of the ribbons to a width of the solar cell is often greater than 3%. By taking a solar cell module having four busbars which is popular in the current market as an example, if the width of the cell is 156 mm, the width of the ribbon is 1.2 mm and a total width of the four ribbons is 4.8 mm, then the ratio of the total width of the ribbons to the width of the solar cells is 4.8/156=3.08%. To realize welding between the ribbons and the cell, a certain amount of silver paste must be consumed to print the busbars with a certain width on the cell. In addition, with using the ribbons with such width, the weight of the ribbons required by each module is large and the cost of the ribbons on each module is also high. Moreover, most of light irradiated on the ribbons cannot be absorbed and utilized by the solar cells due to the shielding of the ribbons, thereby reducing the photoelectric conversion efficiency of the solar cell module. However, if the width of the ribbon is decreased, the photoelectric conversion efficiency of the solar cell module is also reduced since the power loss caused by the resistance of the ribbon is greatly increased due to the decrease of cross sectional area of the ribbon. It is one of technological difficulties in the art to reduce the consumption of the silver paste on the cell and the power consumption of the ribbons of the solar cell module and also increase the photoelectric conversion efficiency of the solar cell module through ingenious design.

EP2020688 A2 teaches a method for manufacturing a solar cell module. The solar cell module includes a plurality of solar cells connected through wiring members. The wiring member may have a width of 1.5 mm. A size of a photoelectric conversion part of the solar cell is 100 mm square.

EP2249398 A1 teaches a solar cell module including a plurality of solar cells connected through wiring members. The wiring member has a plurality of recesses. The resin adhesive enters each of the plurality of recesses and thereby exerts an anchor effect.

WO2012/037191 A2 teaches a photovoltaic cell assembly including photovoltaic cells. The cell includes a photoactive portion sandwiched between a top electrically conductive structure and an opposing conductive substrate layer.

### SUMMARY

The technical solution of the present invention is as defined in the independent claim. Further improvements are provided in the dependent claims. Also provided is a solar cell module.

To achieve the above purpose of the present invention, a technical solution adopted by the present invention is a solar cell module according to claim 1.

The length L of the solar cell in the direction in which the plurality of solar cells are connected in series by the conductive tapes is less than or equal to 10 cm.

The ratio of the total width W of the conductive tapes adopted by each solar cell to the width D of the solar cell is 0.1% to 3%.

The ratio of the total width W of the conductive tapes to the length L of the solar cell is D: 8000 mm to D: 3000 mm.

The solar cell module includes multiple solar cell strings which are in a series structure or a series-parallel hybrid structure, i.e., first in series and then in parallel or first in parallel and then in series.

In the D: 8000 mm to D: 3000 mm, D refers to the width of the solar cell in unit of mm. The present invention has the characteristic that the solar cell with the length L less than or equal to 10 cm is adopted. The solar cell may be directly made of silicon wafers with a length less than or equal to 10 cm, may be a cell formed by cutting a normal entire cell through a slicing technology, and may also be a normal solar cell which is a remaining part in a process of removing defective parts from an entire solar cell having defectives through the slicing technology.

The ratio of the total width W of the conductive tapes to the length L of the corresponding solar cell is D: 8000 mm to D: 3000 mm. Here, "the corresponding solar cell" refers to the solar cell on which the conductive tapes are located, i.e., the ratio of the total width of the conductive tapes adopted by one solar cell to the length of the cell is D: 8000 mm to D: 3000 mm.

Preferably, the length of the solar cell in a direction in which the solar cells are connected in series by the conductive tapes is 0.5 to 10 cm.

Preferably, the length of the solar cell in a direction in which the solar cells are connected in series by the conductive tapes is 3 to 9 cm.

In the above technical solution, the ratio of the total width W of the conductive tapes adopted by each solar cell to the width D of the solar cell is 0.1% to 2%. Further, the ratio of the total width W of the conductive tapes adopted by each solar cell to the width D of the solar cell is 0.5% to 2%, and this ratio is an optimal design ratio, but the width of the conductive tape in such design may be narrow, thereby increasing difficulty of mass production.

In the above technical solution, the ratio of the total width W of the conductive tapes adopted by each solar cell to the width D of the solar cell is greater than 2% and less than 3%. Although the ratio does not reach the optimal design effect, it is easy to realize mass production.

In the above technical solution, the conductive tape refers to a metal tape that plays a conductive role. A shape of the metal tape may be a common flat shape, around, a bow, an oval or a polygon, or a flat strip with patterns on a single side or patterns on double sides, i.e., the shape of the metal tape is not limited.

In an embodiment of the above technical solution, a cross section of the conductive tape is a rectangle and a thickness of the conductive tape is 0.05 mm to 0.3 mm.

In another embodiment of the above technical solution, a cross section of the conductive tape is a circle or a bow and a diameter of the conductive tape is 0.1 mm to 0.4 mm.

Hereinbefore, the conductive tape is a metal tape coated with a metal or a metal alloy. The metal alloy coating is classified into three types: high-temperature welding alloy, low-temperature melting alloy and protection alloy.

The high-temperature welding alloy refers to metal or alloy which is melted at a conventional welding temperature and implements the electrical connection through welding, such as tin-lead alloy, tin-silver alloy and the like.

The low-temperature melting alloy refers to metal or alloy which is melted at a temperature of 100°C to 200°C and implements the electrical connection, such as indium-tin alloy and the like which is melted at a laminating temperature and is electrically connected with the cell and the conductive tape.

The protection alloy refers to metal or alloy that only plays a protection role on the conductive tape, and the electrical connection cannot be implemented through the protection layer, such as silver alloy or other protection layers that protect the metal tape from oxidation corrosion.

The classification of the above alloy coating is not limited to this. For example, the tin-lead alloy can be classified into high-temperature welding alloy or protection alloy according to the thicknesses of the tin-lead alloy. The tin-lead alloy which can reach a welding thickness belongs to the high-temperature welding alloy, while the tin-lead alloy which cannot reach the welding thickness belongs to the protection alloy.

Of course, the conductive tape may also be a metal tape without a metal alloy coating.

The solar cells are solar cells with busbars, and the quantity of the busbars on the solar cell is 2-20.

In the above technical solution, the solar cell is formed by cutting an entire solar cell.

In an embodiment of the above technical solution, the solar cell is a half of the entire solar cell formed by cutting the entire solar cell according to a slicing ratio of 1/2. By taking a conventional cell of 156×156 mm as an example, the solar cells of 156×78 mm are obtained according to the slicing ratio of 1/2.

In a second embodiment of the above technical solution, the solar cell is 1/3 of the entire solar cell formed by cutting the entire solar cell according to a slicing ratio of 1/3.

In a third embodiment of the above technical solution, the solar cell sheet is 1/4 of the entire solar cell formed by cutting the entire solar cell according to a slicing ratio of 1/4. An existing conventional solar cell is generally 156×156 mm. After slicing, solar cells with a length less than or equal to 10 cm can be obtained, and still have a width of 156 mm.

Preferably, widths of the conductive tapes adopted by the solar cells are equal.

In the above technical solution, the cells with busbars and the conductive tapes are adopted. The conductive tape herein may be a metal tape coated with a high-temperature welding alloy, such as a ribbon in which copper base material is coated with tin-lead alloy, and the conductive tape implements the electrical connection through welding or a conductive adhesive. The conductive tape may also be the above metal tape with or without protection alloy coating, which is electrically connected with the cell through the conductive adhesive.

The principle of the present invention is described below. The resistance power loss of the conductive tape of the solar cell module is A ∗ A ∗ B(p/h) ∗ J_{mp/}(m ∗ Vₘₚ ∗ W_{B}), where A is the length of the solar cell; B is half of a spacing between two busbars; p is a bulk resistivity of the conductive tape; h is the thickness of the conductive tape; Jₘₚ is a current density of a maximum working point; m is a constant; Vₘₚ is a voltage in a solar cell unit at the maximum working point; and W_{B} is half of the width of the conductive tape. The shading power loss of the conductive tape of the solar cell module is n ∗ W_{B}/B, where n is a constant that represents reflectivity in the conductive tape. The optimal width of the conductive tape shall satisfy: a derivative is taken with respect to W_{B} by a sum of the resistance power loss and the shading power loss of the conductive tape is equal to 0. Through derivation, for a flat conductive tape with a rectangular or approximately rectangular cross section, the optimal W_{B} = A ∗ B(p ∗ Jₘₚ/(h ∗ m ∗ n ∗ Vₘₚ))^{1/2} is. For a circular or approximately circular conductive tape, an optimal diameter (i.e., an optimal width) W_{B} = (4A² ∗ B² ∗ p ∗ Jₘₚ/(3π ∗ m ∗ n ∗ Vₘₚ))^{1/3}. Therefore, W_{B}/B has a positive correlation with A, i.e., a ratio of the total width W of the conductive tapes adopted by each solar cell to the width D of the solar cell has a positive correlation with the length of the solar cell.

Since the above technical solution is applied, compared with an existing art, the present invention has the following advantages:
1. The present disclosure designs a new solar cell module, further designs a conductive tape with reasonable width by using solar cells with the length less than or equal to 10 cm, and proposes the ratio of the total width of the conductive tapes to the length of the solar cell. The present disclosure perfectly harmonizes a contradiction between the shading loss and the resistance loss of the conductive tape, and realizes maximization of output power. It is proved by experiments that compared with an existing art in which an entire solar cell is used, on a premise of adopting the same amount of the silicon wafers, the shading loss and the resistance loss are greatly reduced and the output power of the module is greatly increased; and an unexpected technical effect is obtained;
2. With the present invention, the amount of paste and the conductive tapes are saved, the cost is reduced. Therefore, the present invention has positive practical significance.
3. The present invention is well compatible with the existing technology, and is easy in preparation, low in cost and is worthy of promotion and application.

### DETAILED DESCRIPTION

The present invention is further described below in conjunction with embodiments.

### Embodiment 1

A solar cell module includes one solar cell string having 120 solar cells connected in series by ribbons.

The solar cells in the solar cell string have the same size, and each of the solar cells is half (i.e., 156×78 mm) of an entire solar cell (156×156 mm) formed by cutting the entire solar cell wafer according to a slicing ratio of 1/2. Each solar cell is provided with four busbars each having a width of 0.5 mm, and a total width of the four busbars accounts for 1.28% of a width of the solar cell.

Each solar cell is provided with four ribbons. A width of each of the four ribbons is 0.6 mm, and a thickness h of each of the four ribbons is 0.2 mm. A total width W of the ribbons covered on each solar cell is 2.4 mm, the total width W accounts for 1.54% of the width of the solar cell; and W/D = L/5070 mm.

### Embodiment 2

A solar cell module includes six solar cell strings each having 20 solar cells connected in series by ribbons. Every two solar cell strings form a parallel unit, so there are three parallel units. The three parallel units are connected in series.

Each solar cell in the solar cell strings has the same size, which is half (i.e., 156×78 mm) of an entire solar cell (156×156 mm) formed by cutting the entire solar cell according to a slicing ratio of 1/2. Each solar cell is provided with four busbars each having a width of 0.8 mm and a thickness h of 0.15 mm. A total width W of ribbons covered on each solar cell is 3.2 mm, a ratio of W to the width of the solar cell is 2.05%; and W/D = L/3803 mm.

### Embodiment 3

A solar cell module includes one solar cell string having 240 solar cells connected in series by ribbons.

Each solar cell in the solar cell string has the same size, which is a quarter of an entire solar cell (156 × 156 mm) formed by cutting the entire solar cell according to a slicing ratio of 1/4, that is, each solar cell is 156×39 mm. Each solar cell is provided with four busbars. A width of each of the four busbars is 0.2 mm; and a ratio of a total width of the busbars to a width of the solar cell is 1.28%.

Each solar cell is provided with four strip-shaped ribbons. A width of each of the four ribbons is 0.3 mm, and a thickness h is 0.2 mm. A total width W of the ribbons covered on each solar cell is 1.2 mm; a ratio of the total width W to the width of the solar cell is 0.77%; and W/D = L/5070 mm.

### Embodiment 4

A solar cell module includes one solar cell string formed by 240 solar cells which are connected in series by ribbons.

Each solar cell in the solar cell string has the same size.. Each solar cell is formed by cutting an entire solar cell (156×156 mm) according to a slicing ratio of 1/4, that is, the size of each solar cell is 156×39 mm. Each solar cell is provided with six busbars. A width of each of the six busbars is 0.2 mm, and a ratio of a total width of the busbars to a width of the solar cell is 0.77%.

Each solar cell is provided with six circular ribbons. A diameter of each of the six ribbons is 0.28 mm, a total width W of the ribbons covered on each solar cell is 1.68 mm; a ratio of the total width W to the width of the solar cell is 1.08%; and W/D = L/3621 mm.

### Embodiment 5 (Not covered by the present invention)

A solar cell module includes one solar cell string formed by 120 solar cell sheets which are connected in series by conductive tapes.

Each solar cell in the solar cell string has the same size. Each solar cell is formed by cutting an entire solar cell (156×156 mm) according to a slicing ratio of 1/2. That is, the size of each solar cell is 156×78 mm.

The solar cell is provided without busbar. Two solar cells are connected with each other by means of four conductive tapes. A width of the conductive tape is 0.8 mm, and a thickness h is 0.15 mm. A surface of the conductive tape is coated with silver, and the conductive tapes and the solar cell are electrically connected via conductive adhesives.

A total width W of the conductive tapes covered on each solar cell is 3.2 mm; a ratio of the total width W to the width of the solar cell is 2.05%; and W/D = L/3803 mm.

### Reference Example 1

A solar cell module includes one solar cell string formed by 60 solar cells which are connected in series by ribbons.

The solar cells in the solar cell string have a same size, and an entire solar cell (156× 156 mm) is adopted for each solar cell.

Each solar cell is provided with four busbars each having a width of 1.1 mm.

Each solar cell is provided with four ribbons. A width of each of the four ribbons is 1.2 mm, and a thickness h is 0.2 mm. A ratio of a total width W of the ribbons covered on each solar cell to the width of the solar cell is 3.08%.

A ratio of the total width W of the ribbons to a length L of the corresponding solar cell is 1: 32.5.

### Reference Example 2

A solar cell module includes one solar cell string formed by 60 solar cell connected in series by conductive tapes.

The solar cells in the solar cell string have a same size, and an entire solar cell (156× 156 mm) is adopted for each solar cell.

Each solar cell is not provided with busbars, and two solar cells are connected with each other by means of four conductive tapes. A width of each of the conductive tapes is 1.2 mm, and a thickness h is 0.2 mm. A surface of each conductive tape is coated with silver, and the conductive tapes and the cells are electrically connected via conductive adhesives.

A total width W of the conductive tapes is 4.8 mm, a ratio of the total width W to the width of the solar cell is 3.08%; and a ratio of the total width W of the ribbons covered on each solar cell to a length L of the corresponding solar cell is 1: 32.5.

Tests of the shading loss, the resistance loss and the output power, and electrical performance tests are made to above embodiments and reference examples. Comparison is made as follows:

| | Width of conductive tape | Pmax | Voc | Isc | FF |
|---|---|---|---|---|---|
| Embodiment 1 | 0.6 mm | 267.9 | 75.72 | 4.56 | 77.60% |
| Embodiment 2 | 0.8 mm | 265.8 | 37.86 | 9.05 | 77.59% |
| Embodiment 3 | 0.3 mm | 271.7 | 151.44 | 2.30 | 78% |
| Embodiment 4 | 0.28 mm | 274.6 | 151.45 | 2.31 | 78.50% |
| Reference example 1 | 1.2 mm | 260.1 | 37.77 | 8.97 | 76.76% |
| Embodiment 5 | 0.8 mm | 266 | 37.88 | 9.05 | 77.59% |
| Reference example 2 | 1.2 mm | 260.5 | 37.84 | 8.97 | 76.76% |

It can be seen from the above table that compared with the existing entire solar cell (reference example 1), on a premise of using the same amount of the silicon wafers, the width of the busbar of the cell is greatly reduced, the consumption of silver paste is greatly decreased, and the consumption of the conductive adhesive is greatly reduced, but the power of the module is still increased greatly.

Thus, the shading loss and the resistance loss of the present disclosure are greatly reduced and the output power of the module is greatly increased; and an unexpected technical effect is obtained. Meanwhile, since narrower and thinner conductive tapes are used in the present disclosure, the consumption of the conductive tapes of the module is greatly decreased, thereby saving cost. Meanwhile, since narrower and thinner conductive tapes are used in the present disclosure, the width of the busbar of the corresponding cell is also narrowed, thereby decreasing consumption of paste for a front surface printing and consumption of paste for a back electrode of the cell and also saving the cost. Meanwhile, an area of an aluminum back surface field of the corresponding cell is increased, which is favorable for further increasing power output of the module.

## Claims

1. A solar cell module, comprising at least one solar cell string, each of which comprises a plurality of solar cells connected in series by conductive tapes,
wherein each solar cell is provided with at least two busbars, and a length L of the solar cell in a busbar direction is less than or equal to 10 cm;
wherein a ratio of a total width W of the conductive tapes adopted by the solar cell to a width D of the solar cell is 0.1% to 3%; and
wherein a ratio of the total width W of the conductive tapes adopted by the solar cell to the length L of the solar cell is D : 8000 mm to D : 3000 mm, wherein D refers to the width of the solar cell in unit of mm,
**characterised in that** a ratio of a total width of the at least two busbars for each solar cell to the width of the solar cell is 0.1% to 2%.

2. The solar cell module according to claim 1, wherein the length of the solar cell in the busbar direction is 3 cm-9 cm.

3. The solar cell module according to claim 1, wherein each solar cell is provided with 2-20 busbars.

4. The solar cell module according to claim 1, wherein the solar cell is formed by cutting an entire solar cell.

5. The solar cell module according to claim 4, wherein each of the solar cells is a half of the entire solar cell formed by cutting the entire solar cell according to a slicing ratio of 1/2.

6. The solar cell module according to claim 1, wherein the quantity of the conductive tapes adopted by each solar cell is the same as the quantity of the busbars thereof.

7. The solar cell module according to claim 1, wherein each conductive tape adopted by the solar cell has the same width.

## Patentansprüche

1. Solarzellenmodul, umfassend mindestens einen Solarzellenstring, von denen jeder eine Vielzahl von Solarzellen umfasst, die durch leitfähige Bänder in Reihe geschaltet sind,
wobei jede Solarzelle mit mindestens zwei Sammelschienen versehen ist und eine Länge L der Solarzelle in einer Sammelschienenrichtung kleiner als oder gleich 10 cm ist;
wobei ein Verhältnis einer Gesamtbreite W der leitfähigen Bänder, die durch die Solarzelle auf eine Breite D der Solarzelle übernommen wird, 0,1 % bis 3 % beträgt, und
wobei ein Verhältnis der Gesamtbreite W der leitfähigen Bänder, die durch die Solarzelle auf eine Länge L der Solarzelle übernommen wird, D : 8000 mm bis D : 3000 mm beträgt, wobei sich D auf die Breite der Solarzelle in der Einheit mm bezieht,
**dadurch gekennzeichnet, dass**
ein Verhältnis einer Gesamtbreite der mindestens zwei Sammelschienen für jede Solarzelle zu der Breite der Solarzelle 0,1 % bis 2 % beträgt.

2. Solarzellenmodul nach Anspruch 1, wobei die Länge der Solarzelle in der Sammelschienenrichtung 3 cm-9 cm beträgt.

3. Solarzellenmodul nach Anspruch 1, wobei jede Solarzelle mit 2-20 Sammelschienen versehen ist.

4. Solarzellenmodul nach Anspruch 1, wobei die Solarzelle durch ein Schneiden einer gesamten Solarzelle ausgebildet wird.

5. Solarzellenmodul nach Anspruch 4, wobei jede der Solarzellen eine Hälfte der gesamten Solarzelle ist, die durch das Schneiden der gesamten Solarzelle gemäß einem Schneideverhältnis von 1 / 2 ausgebildet wird.

6. Solarzellenmodul nach Anspruch 1, wobei die Menge der leitfähigen Bänder, die durch jede Solarzelle übernommen werden, die gleiche wie die Menge der Sammelschienen davon ist.

7. Solarzellenmodul nach Anspruch 1, wobei jedes leitfähige Band, das durch die Solarzelle übernommen wird, die gleiche Breite aufweist.

## Revendications

1. Module de cellules solaires, comprenant au moins une chaîne de cellules solaires, chacune d'entre elles comprenant une pluralité de cellules solaires connectées en série par des bandes conductrices,
dans lequel chaque cellule solaire est pourvue d'au moins deux barres omnibus, et une longueur L de la cellule solaire dans une direction de barre omnibus est inférieure ou égale à 10 cm ;
dans lequel un rapport entre la largeur totale W des bandes conductrices adoptées par la cellule solaire et une largeur D de la cellule solaire est de 0,1 % à 3 % ; et
dans lequel un rapport entre la largeur totale W des bandes conductrices adoptées par la cellule solaire et la longueur L de la cellule solaire est D : 8000 mm à D : 3000 mm, où D se réfère à la largeur de la cellule solaire en unité de mm, **caractérisé en ce que**
un rapport d'une largeur totale des au moins deux barres omnibus pour chaque cellule solaire à la largeur de la cellule solaire est de 0,1 % à 2 %.

2. Module de cellules solaires selon la revendication 1, dans lequel la longueur de la cellule solaire dans la direction de la barre omnibus est de 3 cm à 9 cm.

3. Module de cellules solaires selon la revendication 1, dans lequel chaque cellule solaire est pourvue de 2 à 20 barres omnibus.

4. Module de cellules solaires selon la revendication 1, dans lequel la cellule solaire est formée en découpant une cellule solaire entière.

5. Module de cellules solaires selon la revendication 4, dans lequel chacune des cellules solaires est une moitié de la cellule solaire entière formée en découpant la cellule solaire entière selon un rapport de tranchage de 1/2.

6. Module de cellules solaires selon la revendication 1, dans lequel la quantité de bandes conductrices adoptées par chaque cellule solaire est la même que la quantité de barres omnibus de celle-ci.

7. Module de cellules solaires selon la revendication 1, dans lequel chaque bande conductrice adoptée par la cellule solaire a la même largeur.
